(19) Europäisches Patentamt
European Patent Office
Office européen des brevets

(11) Veröffentlichungsnummer: **0 000 489**
**B1**

# (12) EUROPÄISCHE PATENTSCHRIFT

(45) Veröffentlichungstag der Patentschrift: **12.08.81**

(51) Int. Cl.³: **H 01 L 21/66**, G 01 R 31/28

(21) Anmeldenummer **78100335.5**

(22) Anmeldetag: **10.07.78**

(54) **Verfahren zum zerstörungsfreien Prüfen von Halbleitersubstraten.**

(30) Priorität: **25.07.77 US 818908**

(43) Veröffentlichungstag der Anmeldung: **07.02.79 Patentblatt 79/3**

(45) Bekanntmachung des Hinweises auf die Patenterteilung: **12.08.81 Patentblatt 81/32**

(84) Benannte Vertragsstaaten: **DE FR GB**

(56) Entgegenhaltungen:
**ELECTRONICS, Vol. 42, Nr. 13, 23. Juni 1969 New York (USA) Reports Pinholes »Finding pesky flaws in oxide«, Seiten 45—46**

(73) Patentinhaber: **International Business Machines Corporation, Armonk, N.Y. 10504 (US)**

(72) Erfinder: **Markovits, Gary, 7 Spratt Avenue, Poughkeepsie N.Y. 12603 (US)**

(74) Vertreter: **Oechssler, Dietrich, Dr.rer.nat. Dipl.-Chem., Schönaicher Strasse 220, D-7030 Böblingen (DE)**

EP 0 000 489 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

# Verfahren zum zerstörungsfreien Prüfen von Halbleitersubstraten

Die Erfindung betrifft ein Verfahren zum Auffinden elektrisch aktiver Störstellen in einem einkristallinen Halbleitersubstrat, wobei das Halbleitersubstrat in eine verdünnte Elektrolytlösung gelegt, gegenüber dieser negativ vorgespannt und beleuchtet wird.

Eine Reihe von Verfahren sind beschrieben worden, um Fehl- oder Störstellen in einkristallinen Halbleitergegenständen, wie z. B. Siliciumplättchen, zu entdecken. Die Entdeckung solcher Störstellen ist von besonderer Wichtigkeit bei der Herstellung von integrierten Schaltkreisen, wo Störstellen in den Oberflächenschichten der Halbleitersubstrate die Ausbeute an verwendbaren Chips mit integrierten Schaltungen reduzieren können. Zu diesen Methoden gehören beispielsweise das Anfertigen von Schrägschliffen und das Anätzen der angeschliffenen Fläche, die Raster-Oszillator-Topographie (SOT) und Kondensator-Leckstrommessungen. In letzter Zeit sind Kathodenstrommessungen dazu benutzt worden, um Halbleitersubstrate vom P-Typ zu charakterisieren, wozu das Substrat in einer verdünnten, wäßrigen Säureelektrolytlösung mit einer Spannung von wenigen Volt negativ vorgespannt wird. Es wird angenommen, daß unter dem Einfluß des elektrischen Feldes eine Schicht von aus dem Elektrolyten stammenden positiven Ionen sich an der Grenzfläche zwischen dem Halbleiter und der Lösung bildet, während die Löcher von der Halbleiteroberfläche in das Substratmaterial hinein in eine Tiefe W gestoßen werden. Nur die negativen Akzeptorionen bleiben in dieser Verarmungszone, und ihre Ladung gleicht die positive Ladung der Ionenschicht an der Grenzfläche zwischen dem Halbleiter und der Lösung aus. Wird nun unter diesen Bedingungen eine Fehlstelle Elektronen-Lochpaare innerhalb der Verarmungszone erzeugt, werden die Löcher durch das elektrische Feld in das Halbleitermaterial hineingestoßen, während die Elektronen zur Grenzfläche zwischen dem Halbleiter und der Lösung gezogen werden, wo sie mit den positiven Ionen in der Lösung an der Grenzfläche reagieren können. Dieser Mechanismus erzeugt einen Strom, welcher außerhalb der Meßzelle gemessen werden kann. Es wird angenommen, daß die Reaktion zwischen den Elektronen und den positiven Ionen in der Lösung nach der folgenden Reaktionsgleichung abläuft:

$$H_3O^+ + e^- \rightarrow 1/2\ H_2 + H_2O$$

Da die $H_3O^+$-Ionenkonzentration größer ist als diejenige der Minoritätsträger an der Grenzfläche zwischen dem Halbleiter und der Lösung wird die Reaktion durch die Geschwindigkeit der Erzeugung von Elektronen-Lochpaaren oder in anderen Worten, durch die elektrisch aktiven Fehlstellen in der Verarmungszone gesteuert. Die Messung des Kathodenstromes kann so für eine Charakterisierung der Qualität des Halbleitersubstrats verwendet werden. Das Halbleitermaterial nimmt nicht an der elektrochemischen Reaktion teil, so daß das Substrat nicht verändert wird. Es ist auch bekannt, daß künstliche Fehlstellen in einem Siliciumplättchen mittels eines hochintensiven Lichtblitzes erzeugt werden konnten, wenn eine Vorspannung von etwa 5 Volt an das Substrat gelegt wurde. In diesem Fall wurde, wenn die Zelle beleuchtet wurde, eine beachtliche Gasentwicklung auf dem Plättchen beobachtet.

Obwohl die Kathodenstrommessungen nicht zerstörend sind und schnell durchgeführt werden können, geben solche Messungen keinen Hinweis auf die Natur oder die Lage der Störstellen. Beispielsweise können eine einzelne große Fehlstelle an einem Ort eines Halbleiterplättchens und eine große Anzahl von kleinen, aber wesentlichen Störstellen, welche über ein relativ großes Gebiet eines zweiten Plättchens verteilt sind, denselben Kathodenstrom ergeben. Im ersten Fall würde das Plättchen für die Herstellung integrierter Schaltungen geeignet sein, weil die Störstelle auf ein Chip begrenzt ist oder könnte sogar sich in dem Teil des Plättchens befinden, welcher beim Zerschneiden wegfällt, so daß höchstens ein kleiner Ausbeuteverlust eintreten würde. Dieses Plättchen würde als »gutes« Plättchen angesehen werden, während das zweite Plättchen, welches eine große Anzahl von kleinen Störstellen aufweist, für die Herstellung integrierter Schaltungen ungeeignet sein würde.

Ein Verfahren zum Abbilden der Qualität eines Halbleiterplättchens in Form einer »Landkarte« des Plättchens ist in dem Artikel »Inline Wafer Quality Monitor« im IBM Technical Disclosure Bulletin, Band 18, Nr. 12, Mai 1976, Seite 4012 offenbart. Bei diesem Verfahren wird eine Anordnung von lichtemittierenden Dioden dazu verwendet, unterschiedliche Bereiche des Plättchens zu beleuchten, so daß Kathodenstrominformationen von unterschiedlichen Bereichen des Plättchens erhalten werden. In dem Artikel »Scanning Cathodic Current Spectroscopy« im IBM Technical Disclosure Bulletin, Band 18, Nr. 11, April 1976, Seite 3623 wird die Anwendung eines Laserstrahls zum Rastern des Halbleitermaterials beschrieben, was dazu dient, die Qualität der Verarmungszone in Form einer »Landkarte« abzubilden. Die »Landkarte« der Halbleiterqualität kann erhalten werden, weil die Fehlstellenbereiche unter den genannten Bedingungen eine Stromabnahme verursachen. Es ist auch bekannt, Risse in Deckschichten auf Halbleitern oder Metallen zu lokalisieren, indem das Substrat in einem Elektrolyt unter Anlegung einer Vorspannung behandelt wird, so daß sich Wasserstoff an den Stellen entwickelt, wo das Substratmaterial der Lösung ausgesetzt ist. Ein solches Verfahren ist im Artikel »Pinholes:

Finding Pesky Flaws in Oxide«, Electronics, Vol. 42, Nr. 13, Seite 45, offenbart. Metalle sind auf Spannungs-Inhomogenitäten geprüft worden, indem man sie in eine Schwefelsäureelektrolytlösung unter Anlegung einer Vorspannung von 6 Volt legte, wobei naszierender Wasserstoff erzeugt wird, welcher von den Inhomogenitäten absorbiert wird. Die Metalloberfläche wird dann mit einem Kunststoffilm bedeckt und anschließend erhitzt, um den Wasserstoff zu desorbieren, was eine Blasenbildung im Film an den Stellen wo sich Störstellen befinden, verursacht.

Es ist die Aufgabe der Erfindung, ein einfaches, nicht zerstörendes und schnell durchführbares Verfahren zum Feststellen und Registrieren von elektrisch aktiven Störstellen in einkristallinen Halbleitersubstraten, von defekten P/N-Übergängen und von gestörten Bereichen großflächiger P/N-Übergängen bezüglich ihrer Lage und des Ausmaßes der Störung anzugeben.

Diese Aufgabe wird mit einem Verfahren gemäß dem Patentanspruch 1 gelöst. Die im Oberbegriff des Anspruchs 1 enthaltenen Merkmale sind aus dem Artikel »Scanning Cathodic Current Spectroscopy« im IBM Technical Disclosure Bulletin, Band 18, Nr. 11, April 1976, Seite 3623 bekannt.

Das erfindungsgemäße Verfahren ergibt eine gute Übereinstimmung mit anderen zerstörenden und/oder zeitaufwendigen Verfahren, welche bisher dazu benutzt wurden, um elektrisch aktive Störstellen in der Oberfläche von Halbleitersubstraten zu lokalisieren. Mittels des bei der Durchführung des erfindungsgemäßen Verfahrens sich bildenden, aus den an der Substratoberfläche haftenden Wasserstoffbläschen bestehenden Muster lassen sich aber nicht nur die Plätze lokalisieren, an denen sich die Störstellen befinden, vielmehr ist es auch möglich, das Ausmaß der Störung festzustellen, indem die Zeitdauer, während der die Vorspannung an das Substrat gelegt wird, in festgelegter Weise variiert wird. Allgemein läßt sich sagen, daß das erfindungsgemäße Verfahren als Prüfmethode sowohl in der Halbleiterplättchen-Fertigung als auch bei der Herstellung von integrierten Schaltkreisen in vorteilhafter Weise verwendbar ist. Außerdem lassen sich mit dem erfindungsgemäßen Verfahren die Wirkung von verschiedenen Getterprozessen auf die elektrisch aktiven Störstellen ermitteln.

Vorteilhafte Ausgestaltungen des erfindungsgemäßen Verfahrens ergeben sich aus den Unteransprüchen.

Die Erfindung wird an Hand von durch Zeichnungen erläuterten Ausführungsbeispielen beschrieben. Es zeigt

Fig. 1 in schematischer Darstellung eine Vorrichtung, mit welcher das erfindungsgemäße Verfahren durchgeführt werden kann,

Fig. 2 eine teilweise aufgeschnittene Seitenansicht einer Testzelle, mit welcher das erfindungsgemäße Verfahren durchgeführt werden kann,

Fig. 3A in Aufsicht ein Halbleiterplättchen, in welches Stufen geätzt worden sind, indem von aufeinanderfolgenden Stufen zunehmende Materialmengen entfernt worden sind,

Fig. 3B einen Querschnitt durch das in der Fig. 3A gezeigte Plättchen entlang der Linie B-B,

Fig. 4A – B Fotografien von einem Siliciumplättchen vom P-Typ, in welches Stufen geätzt sind und welches Schäden aufweist, wobei es sich bei der Fig. 4A um eine Aufnahme handelt, welche mittels des erfindungsgemäßen Verfahrens erhalten wurde, und bei der Fig. 4B um eine Aufnahme, welche mittels der Raster-Oszillations-Topographie (SOT) erhalten wurde,

Fig. 5A und 5B Fotografien eines Siliciumplättchens, wobei Fig. 5A ein Wasserstoffbläschenmuster zeigt und die Fig. 5B zum Vergleich eine retuschierte Aufnahme desselben Siliciumplättchens vom P-Typ zeigt, aus welcher die Bereiche elektrischer Effekte, wie sie mittels Kondensator-Leckstrommessungen ermittelt worden sind, zu ersehen sind,

Fig. 6A und 6B Fotografien eines Siliciumplättchens vom P-Typ, wobei die Fig. 6A ein Wasserstoffbläschenmuster zeigt und die Fig. 6B zum Vergleich eine retuschierte Fotografie, aus welcher die Bereiche elektrischer Effekte, wie sie mittels Kondensator-Leckstrommessungen ermittelt worden sind, zu ersehen sind, zeigt und

Fig. 7 eine retuschierte Fotografie eines Siliciumplättchens vom P-Typ, welches einen Subkollektorbereich von $N^+$-Typ und eine Oberflächliche Epitaxieschicht von $N^-$-Typ aufweist, wobei aus der Fotografie die Bereiche der elektrischen Defekte, wie sie mittels Kondensator-Leckstrommessungen ermittelt worden sind, zu ersehen sind.

In Fig. 1 ist eine Vorrichtung gezeigt, mit der sich das erfindungsgemäße Verfahren durchführen läßt. Zu der Vorrichtung gehören eine Gleichstromversorgung, welche in der Lage ist, eine Spannung bis zu etwa 65 Volt abzugeben, ein Amperemeter 13, eine Testzelle 19 und eine Quelle weißen Lichts 15, mit welcher die Plättchenoberfläche mit einer Beleuchtungsstärke von mindestens 860 lx bestrahlt werden kann. Eine geeignete Quelle ist ein Wolfram-Scheinwerfer, welcher eine Leistung von 75 Watt erbringt. Ein Schalter 17 ist auch vorgesehen. Die Einzelheiten der Testzelle 19, welche aus Polytetrafluoräthylen bestehen kann, ist in der Fig. 2 gezeigt. Die Zelle 19 ist derartig konstruiert, daß eine vollständige Oberfläche 20 des Halbleiterplättchens 21 der Elektrolytlösung 23 ausgesetzt ist, so daß das Wasserstoffbläschenmuster des ganzen Plättchens zur gleichen Zeit entwickelt werden kann. Das Plättchen 21 ist in die Zelle 19 eingebaut, welche mit einer einen O-Ring aufweisenden vakuumdichten Abdichtungsvorrichtung versehen ist. Das Plättchen 21 wird mittels eines Vakuumstutzens 27 festgehalten und gegen einen mit Graphit imprägnierten Schwamm 29 gedrückt, wodurch ein großflächiger einheitlicher elektrischer Kontakt zu der

Rückseite des Plättchens 21 sichergestellt wird. Der Schwamm 29 ist mit der Kathode der Gleichstromversorgung über den Draht 31 verbunden. Die Anode besteht aus einem Platindraht 33, welcher sich bis in die Lösung 23 erstreckt.

Die Elektrolytlösung wird so ausgewählt, daß sie die Oberfläche des Halbleitersubstrats nicht oxydiert oder in anderer Weise angreift. Verdünnte Schwefelsäurelösungen sind geeignete Elektrolytlösungen. Beispielsweise ist eine etwa 1 bis 2¹/₂ Vol.-%ige Lösung von 96%iger Schwefelsäure in deionisiertem Wasser brauchbar. Andere Konzentrationen könnten auch angewendet werden. Andere Elektrolyte, welche eine Quelle von $H_3O^+$-Ionen sind, wie z. B. Flußsäure und Essigsäure, können auch benutzt werden.

Materialien, welche mittels des erfindungsgemäßen Verfahrens geprüft werden können, sind einkristalline Halbleitermaterialien, wie z. B. Silicium oder Germanium vom P-Typ, und Halbleitersubstrate vom P-Typ, welche eine entweder epitaxial oder durch Diffusion erzeugte Oberflächenschicht vom N-Typ aufweisen. Das Halbleitersubstrat, wie z. B. ein Siliciumplättchen, sollte eine Oberfläche haben, welche sauber und oxidfrei ist. Infolgedessen wird das Substrat zuerst gereinigt, um irgendwelche Oxide, Ablagerungen von organischen Materialien oder andere Filme und Schmutz von der Oberfläche zu entfernen. Dabei kann jeder übliche Halbleiterreinigungsprozeß angewandt werden, mit dem eine saubere, schmutzfreie Oberfläche erhalten werden kann.

Nach der Reinigung wird das Substrat in der Zelle befestigt und der Elektrolyt in die Zelle gegossen. Es sollte darauf geachtet werden, daß während der Prüfung der Elektrolyt nicht bewegt wird. Eine Bewegung des Elektrolyten kann Wasserstoffbläschen von ihrem Platz auf der Oberfläche entfernen, was einen Informationsverlust zur Folge hat. Das Substrat wird einheitlich mit weißem Licht bestrahlt, dessen Lichtintensität an der Substratoberfläche im Bereich zwischen etwa 538 und etwa 807 lx liegt. Es wurde gefunden, daß Lichtintensitäten unter etwas 538 lx — außer an den am stärksten beschädigten Stellen — überhaupt keine Bläschen an den Stellen, wo sich die elektrischen Defekte befinden, erzeugen. Auf der anderen Seite werden bei Lichtintensitäten von etwa 860 lx und darüber im wesentlichen Umfang auch in den Bereichen Wasserstoffbläschen entwickelt, in welchen keine elektrisch defekten Stellen vorhanden sind. Wird eine negative Vorspannung an das Substrat gelegt, bildet sich das Bläschenmuster. Die aktiveren Störstellenplätze werden zuerst Bläschen entwickeln, wobei Zeiten im Bereich zwischen 1 und 15 Sek. ausreichen, um ein Bläschenmuster zu entwickeln, welches den Bereichen von elektrisch aktiven Störstellenplätzen, welche mittels anderer Prüfmethoden bestimmt worden sind, entsprechen. Das Spannungsniveau ist wichtig, da unterhalb etwa 50 Volt und oberhalb etwa 65 Volt nicht in allen Fällen eine gute Übereinstimmung zwischen den Bereichen von elektrisch aktiven Störstellenplätzen im Substrat und dem Bläschenmuster erhalten wird. Hat sich einmal das Bläschenmuster entwickelt, so kann es visuell beobachtet werden oder es kann mittels üblicher fotografischer Mittel festgestellt und aufgenommen werden.

Das Verfahren wird nun an Hand der folgenden Beispiele noch näher erläutert, wobei aber klargestellt sei, daß die Anwendung des Verfahrens nicht auf diese Beispiele beschränkt ist.

### Beispiel 1

Ein Fehlstellen aufweisendes, einkristallines Siliciumplättchen vom P-Typ mit einem spezifischen Widerstand von 2 Ω cm wurde mittels Ätzung mit Stufen versehen, wie es die Figuren 3A und 3B zeigen, wobei die Höhen der Stufen in der Tabelle I gezeigt sind.

Tabelle I

| Stufe | Höhe (µm) |
|---|---|
| 1 | 0 |
| 2 | 8,5 |
| 3 | 5,0 |
| 4 | 3,5 |
| 5 | 9,5 |
| 6 | 5,0 |
| 7 | 5,0 |
| 8 | 3,0 |

Das Plättchen wurde dann gereinigt, um irgendwelche Oxide und Filme aus organischem Material zu entfernen. Oxid kann die Entwicklung von Bläschen verhindern und Filme aus organischem Material können Bläschen an Plätzen hervorrufen, wo sich keine Störstellen befinden.

Das Plättchen wurde gereinigt, indem es in Flußsäure getaucht, unter Ultraschallerregung 10 Min. lang in 5%iger Natriumhypochloritlösung getaucht und in deionisiertem Wasser gespült wurde. Das Plättchen wurde dann 5 Min. lang unter Ultraschallerregung in eine 10 : 1 Mischung aus Wasser und HCl getaucht, wieder mit deionisiertem Wasser gespült, dann 30 Sek. lang in eine 10 : 1 Mischung aus Wasser und Flußsäure getaucht und schließlich in deionisiertem Wasser gespült. Nach dem Reinigen wurde das Plättchen in die Testzelle 19 gelegt und dann wurde eine 2 1/2 Vol.-%ige wäßrige Schwefelsäureelektrolytlösung zugegeben. Die Beleuchtung erfolgte mittels eines 75-Watt-Wolfram-Scheinwerfers, welcher so eingestellt war, daß er eine Beleuchtungsstärke von 753,48 lx an der Plättchenoberfläche erzeugte. Der Schalter 17 wurde geschlossen, um an das Plättchen 5 Sek. lang eine negative Vorspannung von 60 Volt zu legen. Das Bläschenmuster wurde fotografiert. Die Fotografie ist in der Fig. 4A wiedergegeben. Man kann erkennen, daß Wasserstoffbläschen auf den ersten vier Stufen sich gebildet haben. Eine Raster-Oszillator-Topographie (SOT)-Aufnahme, welche in der Fig. 4B wiedergegeben ist, wurde auch aufgenommen, (Einzelheiten dazu siehe beispielsweise in dem Artikel »New X-Ray Diffraction Microscopy Technique for the Study of Imperfections in Semiconductor Crystals«, von Schwuttke im Journal of Applied Physics, Band 36, Nr. 9, September 1965, Seiten 2712–2721). Die dunkleren Bereiche der Topographie zeigen an, daß Fehlstellen in den ersten vier Stufen vorkommen, was dem Bläschenmuster in Fig. 4A entspricht.

Das Plättchen wurde dann senkrecht zu den Stufen zerschnitten, dann wurde die freiliegende Schnittfläche schräg abgeschliffen und schließlich wurde eine verdünnte Sirtl-Ätzlösung (Stammlösung = 1 Gramm $Cr_2O_3$ in 4 ml deionisiertem Wasser, verdünnte Sirtl-Ätzlösung = 1 Teil Stammlösung auf ein Teil Flußsäure) aufgebracht, um die Fehlstellen sichtbar zu machen. Das Ätzmittel wird hergestellt, indem ein Teil einer Stammlösung, welche 1 Gramm $Cr_2O_3$ pro 4 Milliliter deionisiertem Wasser enthält, mit einem Teil Flußsäure gemischt wird. Ausgehend von einer Stelle, ungefähr 2 Millimeter von der Plättchenkerbe, welche in der Fotografie als ein V-Förmiger Einschnitt im Plättchenrand zu erkennen ist, wurden die Tiefen der Fehlstellen optisch gemessen, wobei ungefähr im Abstand von einem Millimeter gemessen wurde, so daß pro Stufe 4 bis 5 Messungen durchgeführt wurden. Die Ergebnisse sind in der folgenden Tabelle II gezeigt.

Tabelle II
(gemessen am Schrägschliff)

| Stufe | Störstellentiefe (μm) |
|---|---|
| 1 | 36 |
| | 36 |
| | 34 |
| | 34 |
| 2 | 28 |
| | 26 |
| | 22 |
| | 26 |
| | 22 |
| 3 | 16 |
| | 16 |
| | 16 |
| | 16 |
| | 14 |
| 4 | 10 |
| | 14 |
| | 12 |
| | 10 |
| | 10 |
| 5 | 0 |
| | 0 |
| | 0 |
| | 0 |
| | 0 |
| 6 | |

Man sieht, daß die Bestimmung mittels Schrägschliffs und Ätzens auch Fehlstellen in den ersten vier Stufen sichtbar macht, so daß die Ergebnisse eine gute Übereinstimmung zwischen allen drei Methoden aufzeigen.

Beispiel 2

Um das erfindungsgemäße Verfahren noch genauer zu erläutern und um die Wichtigkeit der

Einhaltung der richtigen Spannungs- und Beleuchtungsbedingungen aufzuzeigen, wurde ein mit Stufen versehenes Siliciumplättchen vom P-Typ mit einem Durchmesser von 82,5 Millimeter und einem spezifischen Widerstand von 2 Ω cm geprüft. Vorangegangen war das Abschneiden des Plättchens von einem großen Kristall und das Ätzen der Stufen.

Die Höhen der Stufen sind in der Tabelle III aufgelistet.

Tabelle III

| Stufe | Höhe (μm) |
|---|---|
| 1 | 0 |
| 2 | 5,0 |
| 3 | 5,5 |
| 4 | 6,5 |
| 5 | 5,0 |
| 6 | 7,0 |
| 7 | 7,5 |
| 8 | 8,5 |

Das Plättchen wurde, wie im Beispiel 3 unten ausgeführt wird, gereinigt. Die Ergebnisse, welche mit einer 2-volumprozentigen wäßrigen Schwefelsäureelektrolytlösung für mehrere unterschiedliche Negativvorspannungen und Beleuchtungsbedingungen in der Testzelle 19 erhalten wurden, wurden fotografisch festgehalten. Die Fotografien sind zur Reproduktion nicht geeignet. Beim ersten Versuch wurde im Dunkeln 5 Sekunden lang eine negative Vorspannung von 5 Volt an das Plättchen gelegt. Dabei wurde ein leichter Schleier auf der ersten Stufe erzeugt. Es floß ein Strom von 18 mA. Beim zweiten Versuch wurde eine negative Vorspannung von 5 Volt an das Plättchen 5 Sekunden lang angelegt und die Plättchenoberfläche wurde mit einem 75-Watt-Wolfram-Scheinwerfer, welcher von der Plättchenoberfläche einen Abstand von <15,24 cm hatte, so daß die Beleuchtungsstärke auf der Plättchenoberfläche größer als 2690 lx war, beleuchtet. Dabei bedeckten die Wasserstoffbläschen beinahe das gesamte Plättchen, und zwar auch solche Bereiche, welche in der vom gleichen Plättchen stammenden SOT-Aufnahme als fehlerstellenfrei ausgewiesen waren. Beim dritten Versuch wurde unter Bedingungen, welche im Rahmen des erfindungsgemäßen Verfahrens lagen, nämlich mit einer 5 Sekunden dauernden negativen Vorspannung am Plättchen von 60 Volt und einer Beleuchtung der Plättchenoberfläche mit ungefähr 646 lx gearbeitet. Man konnte dabei Bläschen auf den ersten vier Stufen erkennen, was in guter Übereinstimmung mit den dunklen Gebieten war, welche in der SOT-Aufnahme zu sehen waren.

## Beispiel 3

Die folgenden Prüfungen wurden an einem Kupferpolierten Siliciumsubstrat, welches einen spezifischen Widerstand von 2 Ω cm und einen Durchmesser von 82,5 mm hatte, durchgeführt. Die Ergebnisse, welche unter verschiedenen Spannung- und Beleuchtungsbedingungen erhalten worden sind, werden zum Vergleich zusammen mit Kondensator-Leckstrommessungen dargestellt.

Auf dem Substrat wurde bei 1000°C eine 500 nm dicke Siliciumdioxidschicht thermisch aufgewachsen. Aluminiumpunkte, welche einen Durchmesser von ungefähr 1,5 mm hatten, wurden auf der Oxidschicht abgeschieden und anschließend wurden die Kondensator-Leckströme an jedem dritten Punkt gemessen. Eine Karte der Punkte, an denen die Leckströme größer als 6 Nanoampere waren, ist in der Fig. 5B dargestellt. Da nur jeder dritte Punkt geprüft wurde, wurde immer dann, wenn an einem geprüften Punkt 6 Nanoampere überschritten wurden, eine Anordnung von neun Punkten, welche die 8 den Meßpunkt umgebenden Punkte einschloß, in der Fotografie mit Tinte schwarz gemacht. Dies ergibt eine flächentreue Gewichtung der Bauteile mit Leckströmen ober- und unterhalb des 6 Nanoampere-Niveaus. Die Aluminiumpunkte wurden mittels eines Aluminiumätzmittels entfernt und das Oxid wurde mit Flußsäure abgelöst. Das Substrat wurde gereinigt, indem es 5 Min. lang in ein ultraschallerregtes Halbleiterreinigungsbad gelegt wurde, anschließend wurde in deionisiertem Wasser gespült. Es folgte in 30 bis 60 Sek. dauerndes zweites Eintauchen in verdünnte Flußsäure (10 Vol.-% HF in Wasser), eine Spülung in deionisiertem Wasser, ein 1 Min. dauerndes Eintauchen in das Reinigungsbad und eine abschließende Wasserspülung.

Das gereinigte Substrat wurde in die Testzelle 19 gelegt, in welcher sich eine 2 Vol.-%ige Schwefelsäurelösung befand, und dann wurde 5 Sek. lang im Dunkeln eine Vorspannung von −5 Volt an das Substrat gelegt. Unter diesen Bedingungen konnte keine Wasserstoffentwicklung festgestellt werden. Es floß ein Strom von 9 Milliampere. Als nächstes wurde 5 Sek. lang eine negative Vorspannung von 5 Volt an das Substrat gelegt und außerdem wurde die Plättchenoberfläche mit einer Beleuchtungsstärke, welche größer als 2690 lx war, beleuchtet. Es floß ein Strom von 112 mA. Unter diesen Bedingungen fand in zwei Quadranten der

Oberfläche eine Wasserstoffentwicklung statt. Es war aber so, daß die Wasserstoffentwicklung in einem dieser Quadranten nicht mit den Störstellen, welche aufgrund von Kondensator-Leckstrommessungen in der Fig. 5B eingetragen worden sind, übereinstimmen. Als nächstes wurde an das Plättchen eine negative Vorspannung von 60 Volt 5 Sek. lang gelegt, wobei die Plättchenoberfläche mit einer Beleuchtungsstärke von etwa 645 lx beleuchtet wurde. Bei Spannungen und Beleuchtungsstärken, welche in dieser Größenordnung liegen, wird das erfindungsgemäße Verfahren durchgeführt. Das Wasserstoffbläschenmuster, welches sich entwickelte, wurde fotografiert. Das Ergebnis zeigt die Fig. 5A. Man sieht, daß die Störstellenplätze, welche mittels des Bläschentests bestimmt wurden (siehe Fig. 5A), gut mit denjenigen, die in der Fig. 5B gezeigt sind, übereinstimmen. Die Fehlstellen befinden sich entlang der Peripherie des Substrats und erstrecken sich in den oberen rechten Quadranten des Substrats hinein.

Die oben beschriebenen Prüfungen wurden wiederholt mit einer Probe, welche auch ein kupferpoliertes Siliciumsubstrat mit einem Durchmesser von 82,5 mm und einem spezifischen Widerstand von 2 Ω cm war. Auf dem Substrat befand sich eine 500 nm dicke Siliciumdioxidschicht, welche bei 1000° C thermisch aufgewachsen worden war. Aluminiumpunkte waren auf der Oxidschicht abgeschieden und Kondensator-Leckströme wurden an jedem dritten Punkt gemessen. Eine Karte mit den Kondensator-Leckströmen, welche größer als 6 Nanoampere sind, ist in der Fig. 6B gezeigt. Nach dem Ablösen des Aluminiums und des Oxids wurde das Substrat im Reinigungsbad und in Flußsäure gereinigt, wie es oben beschrieben worden ist. Mit der Probe wurde dann der Bläschentest in der Testzelle 19 durchgeführt, wobei ein Elektrolyt verwendet wurde, welcher eine 2 Vol.-%ige Lösung von Schwefelsäure in deionisiertem Wasser war. Zunächst wurde im Dunkeln 5 Min. lang eine negative Vorspannung von 5 Volt an das Siliciumsubstrat gelegt. Dabei wurde keine Wasserstoffentwiclung festgestellt. Es floß ein Strom von 3 mA. Bei einer 5 Sek. lang dauernden Bestrahlung der Plättchenoberfläche mit einer Beleuchtungsstärke, welche größer 2690 lx war, wobei eine negative Vorspannung von 5 Volt angelegt wurde, wurde nur eine sehr kleine Wasserstoffmenge gebildet. Es floß ein Strom von 120 mA. Unter erfindungsgemäßen Prüfbedingungen, wobei 5 Sek. lang eine negative Vorspannung von 60 Volt an das Siliciumsubstrat angelegt wurde und die Substratoberfläche mit einer Beleuchtungsstärke von etwa 645 lx bestrahlt wurde, wurde ein Wasserstoffbläschenmuster erzeugt, wie es die Fig. 6A wiedergibt. Man sieht, daß eine gute Übereinstimmung zwischen dem in Fig. 6A gezeigten Bläschenmuster und der aufgrund der Kondensator-Leckstrommessungen erstellten und in der Fig. 6B dargestellten Karte vorhanden ist.

## Beispiel 4

Dieses Beispiel soll die Anwendung des erfindungsgemäßen Verfahrens beim Lokalisieren von elektrisch aktiven Störstellen in einer Struktur mit P/N-Übergängen erläutern. Ein Siliciumsubstrat vom P-Typ mit einem spezifischen Widerstand von 20 Ω cm, welche einen ganzflächig eindiffundierten Subkollektorbereich vom $N^+$-Typ und eine diesen abdeckenden Epitaxieschicht vom $N^-$-Typ hat wurde mittels thermischer Oxydation mit einer ungefähr 400 nm dicken Schicht vom Siliciumdioxid bedeckt, auf welcher Aluminiumpunkte niedergeschlagen wurden. Die Kondensator-Leckströme wurden gemessen und eine Karte der Leckströme, welche größer als 6 nA sind, wurde erstellt. Die Karte ist in der Fig. 7 gezeigt. Die Punkte, an welchen mehr als 6 nA gemessen wurden, sind mit Tinte in der Fotografie dunkel gemacht worden.

Die Aluminiumpunkte und ein Teil der Oxidschicht wurden vom Substrat abgelöst. Ein Oxidring, welcher sich um die ganze Peripherie des Substrats, und zwar von der unteren bis zur oberen Oberfläche, erstreckte, wurde stehengelassen, um zu verhindern, daß der Elektrolyt die Epitaxieschicht mit dem Substrat kurzschließt. Ein solcher Kurzschluß würde der Prüfung in die Quere kommen. Das Substrat wurde mittels des Verfahrens, welches im Beispiel 3 beschrieben worden ist, gereinigt und dann in die Testzelle 19 gelegt. An das Substrat wurde 1 Sekunde lang eine negative Vorspannung von 60 Volt gelegt und die Substratoberfläche wurde dabei mit einer Beleuchtungsstärke von etwa 645 lx beleuchtet. Das Wasserstoffbläschenmuster wurde fotografiert. Auf der Fotografie (nicht gezeigt) kann man den Oxidring am Substratrand, an welchem die Bläschen aufhören, sehen. Es besteht eine gute Korrelation zwischen den beiden Prüfungen, welche besonders deutlich ist in dem großen Störstellenbereich in dem unteren rechten Quadranten des in der Fig. 7 gezeigten Substrats.

Im Obengesagten wurde ein nicht zerstörendes Verfahren zur raschen Bestimmung der elektrischen Qualität von Halbleitersubstraten und großflächigen P/N-Übergängen dargestellt. Es kann, wie sich aus den Darlegungen ergibt, leicht an die Erfordernisse bei der Herstellung integrierter Schaltungen angepaßt werden. Es ist eine gute Übereinstimmung mit anderen Prüfungsverfahren, wie z. B. der Raster-Oszillator-Topographie und den Kondensator-Leckstrommessungen, vorhanden, und das erfindungsgemäße Verfahren erfordert nur einen Bruchteil der Zeit, welche für die genannten anderen Verfahren benötigt werden. Für die Verfahren wird eine relativ einfache Testvorrichtung benötigt und mittels üblicher fotografischer Methoden kann die Plättchenqualität leicht dokumentiert werden. Es ist mit dem erfindungsgemäßen Verfahren möglich, zwischen verschiedenen Graden der Störung zu unterscheiden,

indem die Zeitdauer, während der die Vorspannung an das Substrat angelegt wird, in festgelegter Weise variiert wird. Die Prüfung kann nicht nur dazu benutzt werden, um die Plättchenqualität und den Grad der Störung nach dem Versägen, dem chemischen Dünnen, dem Polieren usw. festzustellen, sondern es kann auch dazu benutzt werden, um die Qualität von Epitaxieschichten und/oder P/N-Übergängen zu überprüfen und um den Einfluß von verschiedenen Getterprozessen auf die elektrischen Defekte zu ermitteln.

**Patentansprüche**

1. Verfahren zum Auffinden elektrisch aktiver Störstellen in einem einkristallinen Halbleitersubstrat, wobei das Halbleitersubstrat in eine verdünnte Elektrolytlösung gelegt, gegenüber dieser negativ vorgespannt und beleuchtet wird, dadurch gekennzeichnet, daß die Substratoberfläche mit einer Beleuchtungsstärke im Bereich zwischen etwa 538 und etwa 807 lx beleuchtet wird, daß das Substrat (21) eine festgelegte Zeit gegenüber der Elektrolytlösung (23) mit einer Spannung im Bereich zwischen etwa 50 und etwa 65 Volt vorgespannt wird, so daß sich an den elektrisch aktiven Störstellenplätzen Wasserstoffbläschen entwickeln, und daß die Lage der Wasserstoffbläschen registriert wird.

2. Verfahren nach Anspruch 1, dadurch gekennzeichnet, daß als Elektrolytlösung eine wäßrige Säurelösung verwendet wird.

3. Verfahren nach Anspruch 2, dadurch gekennzeichnet, daß eine Säure aus der Gruppe Schwefelsäure, Flußsäure und Essigsäure verwendet wird.

4. Verfahren nach Anspruch 3, dadurch gekennzeichnet, daß eine wäßrige, etwa 1 bis etwa 2,5 Vol.-%ige Schwefelsäurelösung verwendet wird.

5. Verfahren nach einem oder mehreren der Ansprüche 1 bis 4, dadurch gekennzeichnet, daß die Spannung zwischen etwa 1 und etwa 15 Sek. lang angelegt wird.

6. Verfahren nach einem oder mehreren der Ansprüche 1 bis 5, dadurch gekennzeichnet, daß die Wasserstoffbläschen und ihre Lage fotografisch registriert werden.

7. Verfahren nach einem oder mehreren der Ansprüche 1 bis 6, dadurch gekennzeichnet, daß es auf ein Halbleitersubstrat vom P-Typ angewandt wird.

8. Verfahren nach Anspruch 7, dadurch gekennzeichnet, daß es auf Substrate aus Silicium oder Germanium angewandt wird.

9. Verfahren nach einem oder mehreren der Ansprüche 1 bis 8, dadurch gekennzeichnet, daß es auf ein Halbleitersubstrat angewandt wird, welches mindestens einen P/N-Übergang enthält.

10. Verfahren nach Anspruch 9, dadurch gekennzeichnet, daß es auf ein Halbleitersubstrat vom P-Typ angewandt wird, auf welches eine Epitaxieschicht vom N-Typ aufgebracht ist.

**Claims**

1. Method of locating electrically active damage sites in a monocrystalline semiconductor substrate, the semiconductor substrate being immersed in a dilute electrolyte and being negatively biased relative thereto, and illuminated, characterized in that the substrate surface is illuminated with a light intensity between approximately 538 and approximately 807 lx, that the substrate (21) is biased for a predetermined time relative to the electrolyte (23) with a voltage between approximately 50 and approximately 65 volt so that at the electrically active damage sites hydrogen bubbles are produced, and that the position of the hydrogen bubbles is recorded.

2. Method as claimed in claim 1, characterized in that as electrolyte an aqueous acid solution is used.

3. Method as claimed in claim 2, characterized in that an acid which is selected from the group consisting of sulfuric acid, hydrofluoric acid and acetic acid is used.

4. Method as claimed in claim 3, characterized in that an aqueous sulfuric acid solution of approximately 1 to approximately 2.5% by vol. is used.

5. Method as claimed in one or several of claims 1 to 4, characterized in that the voltage is applied for approximately 1 to approximately 15 sec.

6. Method as claimed in 1 or several of claims 1 to 5, characterized in that the hydrogen bubbles and their position are photographically recorded.

7. Method as claimed in one or several of claims 1 to 6, characterized in that it is applied to a semiconductor substrate of the P-type.

8. Method as claimed in claim 7, characterized in that it is applied to silicon or germanium substrates.

9. Method as claimed in one or several of claims 1 to 8, characterized in that it is applied to a semiconductor substrate containing at least one P/N junction.

10. Method as claimed in claim 9, characterized in that it is applied to a semiconductor substrate of the P-type which has an N-type epitaxial layer deposited thereon.

**Revendications**

1. Procédé pour détecter des emplacements endommagés, électriquement actifs, dans un substrat semi-conducteur monocristallin, dans lequel on place un substrat semiconducteur dans un électrolyte dilué, polarisé négativement par rapport à ce dernier et illuminé, caractérisé en ce que:
la surface du substrat est illuminée avec une intensité de lumière d'environ 538 à environ 807 lx,
le substrat (21) est polarisé pendant une durée prédéterminée par rapport à l'électrolyte (23)

avec une tension d'environ 50 à environ 65 volts de sorte qu'aux emplacement endommagés, électriquement actifs, des bulles d'hydrogène se produisent et que la position des bulles d'hydrogène est enregstrée.

2. Procédé selon la revendication 1, caractérisé en ce que l'électrolyte est constitué par une solution aqueuse d'acide.

3. Procédé selon la revendication 2, caractérisé en ce que l'on utilise un acide sélectionné dans le groupe comprenant l'acide sulfurique, l'acide hydrofluorique et l'acide acétique.

4. Procédé selon la revendication 3, caractérisé en ce que l'on utilise une solution aqueuse d'acide sulfurique dont le pourcentage en volume est d'environ 1 à environ 2,5%.

5. Procédé selon l'une quelconque ou l'une des revendications 1 à 4, caractérisé en ce que l'on applique la tension pendant environ 1 à environ 15 secondes.

6. Procédé selon la revendication 1 l'une plusieurs des revendications 1 à 5, caractérisé en ce que les bulles d'hydrogène et leur position sont enregistrées photographiquement.

7. Procédé selon l'une quelconque des revendications 1 à 6, caractérisé en ce qu'il est appliqué à un substrat semiconducteur du type P.

8. Procédé selon la revendication 7, caractérisé en ce qu'il est appliqué à des substrats de silicium ou de germanium.

9. Procédé selon l'une quelconque des revendications 1 à 8, caractérisé en ce qu'il est appliqué à un substrat semiconducteur comportant au moins une jonction P/N.

10. Procédé selon la revendication 9, caractérisé en ce qu'il est appliqué à un substrat semi-conducteur du type P recouvert d'une couche épitaxiale du type N.

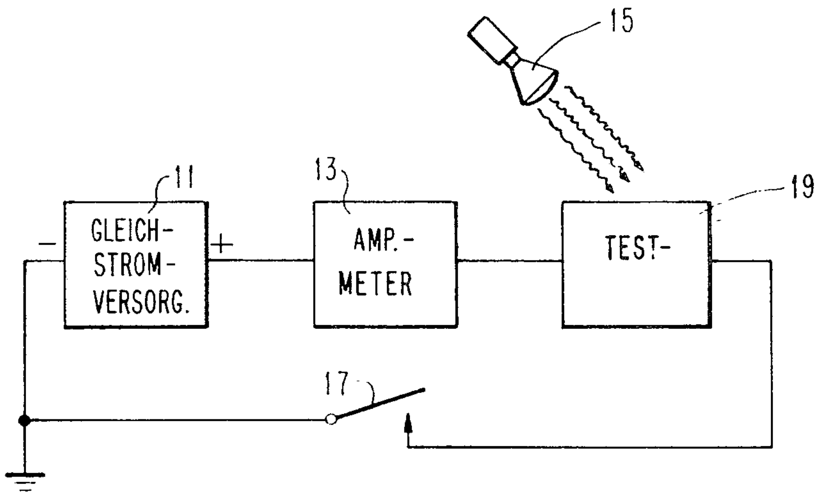


FIG.1

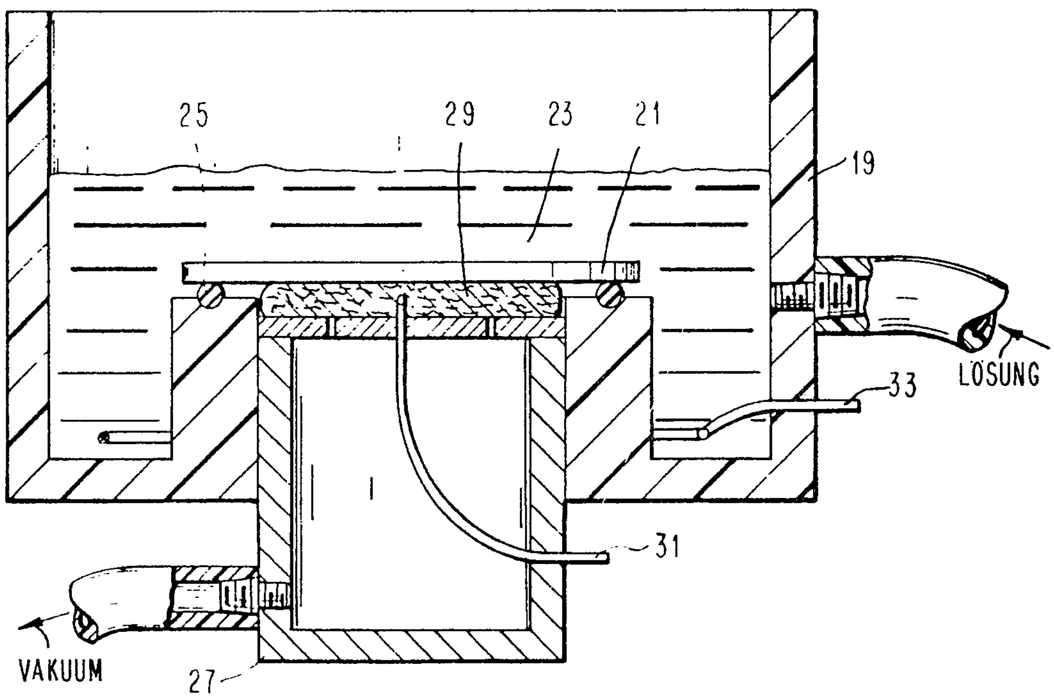


FIG.2

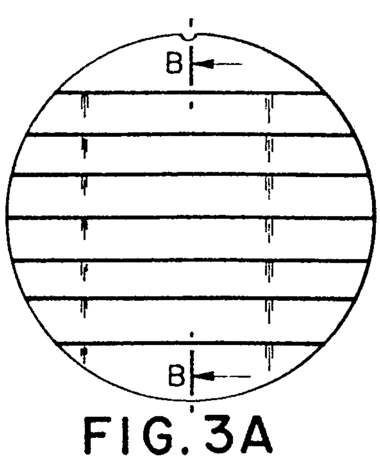


FIG. 3A

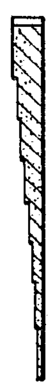

FIG. 3B

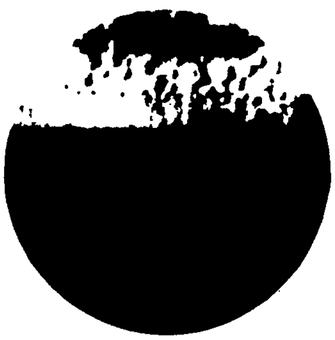

FIG. 4A

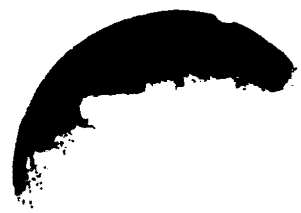

FIG. 4B

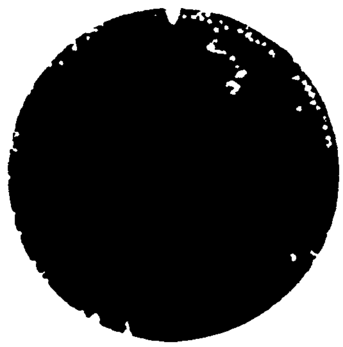

FIG. 5A

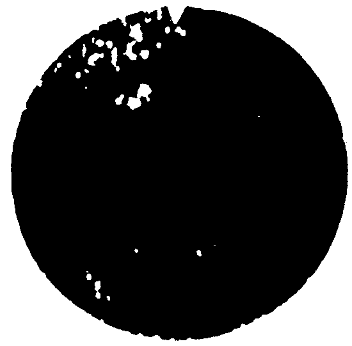

FIG. 6A

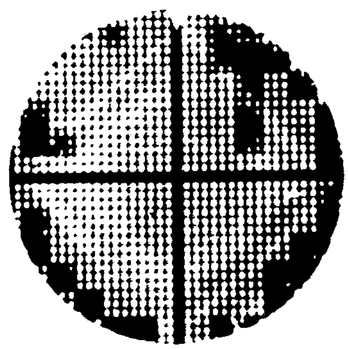

FIG. 5B

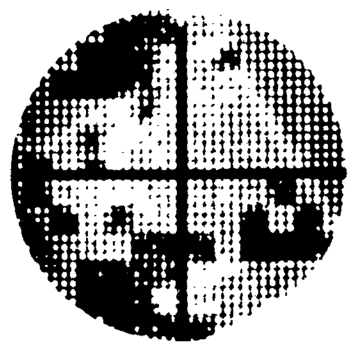

FIG. 6B

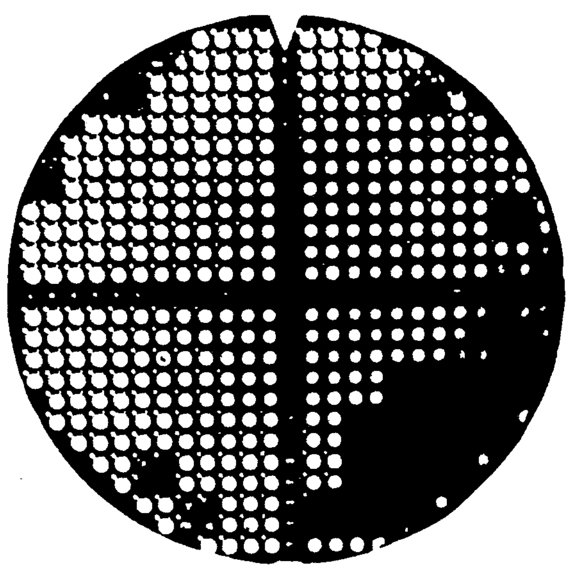

FIG. 7